# FASCICULE DE BREVET EUROPEEN

(11) **EP 0 467 737 B1**
(45) Date de publication et mention de la délivrance du brevet: **13.09.1995**
(21) Numéro de dépôt: 91401818.9
(22) Date de dépôt: 02.07.1991
(51) Int. Cl.: G11B 5/49, G11B 5/39, G11B 15/14

(54) **Dispositif magnétique de lecture à réseau matriciel de têtes de lecture**
Magnetische Wiedergabevorrichtung mit einem matrixartigen Netzwerk von Leseköpfen
Magnetic read-out device with a matrix network of read heads

(30) Priorité: 20.07.1990 FR 9009302
(43) Date de publication de la demande: 22.01.1992
(73) Titulaire: THOMSON-CSF, 75008 Paris (FR)
(72) Inventeur: Coutellier, Jean-Marc, Thomson-CSF, SCPI, F-92045 Paris La Défense (FR); Valet, Thierry, Thomson-CSF, SCPI, F-92045 Paris La Défense (FR); Pirot, François-Xavier, Thomson-CSF, SCPI, F-92045 Paris La Défense (FR); Colineau, Joseph, Thomson-CSF, SCPI, F-92045 Paris La Défense (FR)
(74) Mandataire: Guérin, Michel

(56) Documents cités:
- EP-A- 0 009 531
- DE-B- 1 193 549
- JP-A-61 153 897
- NL-A- 7 510 306
- US-A- 4 275 428
- US-A- 4 616 272
- IBM TECHNICAL DISCLOSURE BULLETIN. vol. 18, no. 11, avril 1976, ARMONK, N.Y.,USA pages 3797 - 3798; T. A. SCHWARZ: "MAGNETORESISTIVE HEAD DRIVE CIRCUIT"
- IBM TECHNICAL DISCLOSURE BULLETIN. vol. 17, no. 12, mai 1975, ARMONK, N.Y., USApages 3778 - 3779; E. G LEAN et al.: "SCANNING TAPPED MAGNETORESISTIVE SENSOR"
- PATENT ABSTRACTS OF JAPAN vol. 7, no. 270 (P-240)(1415) 02 décembre 1983,& JP-A-58 150124

## Description

L'invention concerne les dispositif magnétiques de lecture du type permettant de lire simultanément un grand nombre de pistes magnétiques, notamment à l'aide de têtes de lecture en position fixe par rapport aux pistes magnétiques.

Les têtes de lecture actuellement encore les plus utilisées pour lire des supports magnétiques "haute densité", sont montées sur des têtes tournantes, notamment dans les magnétoscopes. La vitesse de rotation des têtes magnétiques est élevée et elle est combinée au déplacement de la bande magnétique : dans cette configuration, il est possible d'extraire suffisamment de signal avec une tête de lecture purement inductive, ce qui n'est pas le cas quand une telle tête de lecture est fixe par rapport à la bande magnétique.

Mais les solutions à base de têtes magnétiques tournantes présentent des inconvénients, notamment quand au poids et à l'encombrement, et aussi en ce qui concerne la fiabilité, du fait des vitesses de rotation relativement élevées.

La présente invention a pour objet un dispositif magnétique de lecture multipistes, simple à réaliser et pouvant intégrer, sous un faible volume, un grand nombre de têtes de lecture susceptibles de fonctionner en position fixe par rapport à la bande magnétique.

Selon l'invention, un dispositif magnétique de lecture comportant, une pluralité de têtes magnétiques de lecture, un générateur de tension délivrant une tension de commande, chaque tête de lecture incorporant un élément magnéto-résistif présentant une résistance électrique variable en fonction d'un champ magnétique extérieur, est caractérisé en ce qu'il comporte un réseau de conducteurs lignes croisés avec un réseau de conducteurs colonnes, les têtes de lecture étant situées chacune sensiblement à une intersection d'un conducteur ligne avec un conducteur colonne, chaque résistance étant reliée, d'une part par une première extrémité au conducteur ligne de l'intersection correspondante, et d'autre part par une seconde extrémité ou conducteur colonne de la même intersection, et en ce que chaque conducteur ligne reçoit une première polarité de la tension de commande par l'intermédiaire d'un organe de commutation, et en ce que chaque conducteur colonne est relié, d'une part à la seconde polarité de la tension de commande, et d'autre part à un capteur de courant.

L'invention sera mieux comprise à la lecture de la description qui suit, faite à titre d'exemple non limitatif en référence aux figures annexées, parmi lesquelles :
- la figure 1 est un schéma électrique d'un dispositif magnétique de lecture suivant l'invention;
- les figures 2a à 2e illustrent des étapes d'un procédé de réalisation de têtes de lecture magnéto-résistives;
- la figure 3 est une vue en coupe suivant un axe de la figure 2e, et illustre des étapes suivantes du procédé de réalisation.

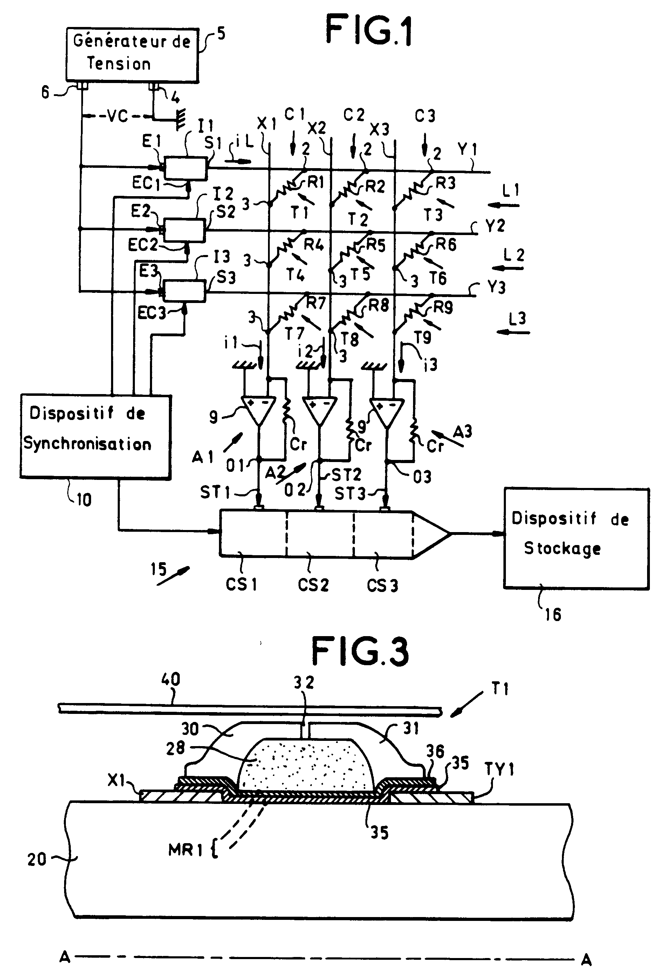

La figure 1 montre un dispositif magnétique de lecture conforme à l'invention, comportant une pluralité de têtes magnétiques de lecture formant un réseau matriciel. Pour simplifier la figure 1, seulement neuf têtes de lecture T1 à T9 sont représentées qui forment trois lignes L1,L2,L3 et trois colonnes C1,C2,C3 de têtes de lecture. Mais bien entendu, dans l'esprit de l'invention le nombre de têtes de lecture peut être différent et notamment beaucoup plus important.

Le dispositif magnétique 1 comporte un réseau de conducteurs lignes Y1 à Y3 et un réseau de conducteurs colonnes X1 à X3. Chaque conducteur ligne Y1 à Y3 et chaque conducteur colonne X1 à X3 correspondent respectivement a une ligne L1 à L3 et à une colonne C1 à C3 de têtes de lecture T1 à T9. Les conducteurs lignes et colonnes Y1 à Y3 et X1 à X3 sont croisés, et à chaque intersection de ces conducteurs correspond une tête de lecture T1 à T9.

Dans le dispositif de lecture de l'invention, le fonctionnement des têtes de lecture T1 à T9 met en oeuvre un effet magnéto-résistif. Les têtes de lecture T1 à T9 comportent chacune un matériau dont la résistivité varie en fonction du champ magnétique auquel est soumis ce matériau. On applique une tension de commande aux bornes de l'élément magnéto-résistif c'est à dire entre des faces ou extrémités opposées de ce matériau : le courant qui est alors engendré dans ce matériau varie avec la résistivité le ce dernier, et les variations de courant traduisent les variations du champ magnétique à lire auquel est soumis l'élément magnéto-résistif.

Les capteurs a effet magnéto-résistifs sont en eux-mêmes bien connus. Ils sont couramment réalisés dans des alliages tels que par exemple le Permalloy (Fe₈₀ Ni₂₀).

On peut trouver des explications détaillées sur l'effet magnéto-résistif et la réalisation de capteur magnéto-résistifs dans l'article de D. THOMPSON paru dans IEEE TRANSACTION ON MAGNETICS, Vol. 11, N° 4, 1975, page 1039.

Les variations du champ magnétique enregistré sur une piste magnétique (non représentée ) étant traduites par une variation de la résistance électrique du matériau magnéto-résistif, c'est sous la forme d'une résistance R1 à R9 que les têtes magnétiques de lecture T1 à T9 sont représentées sur la figure 1.

En pratique, chaque têtes de lecture T1 à T9 est réalisée à proximité d'une intersection d'un conducteur ligne Y1 à Y3 avec un conducteur colonne X1 à X3, de la même intersection. Ainsi par exemple pour la première ligne L1 de tête T1 à T3, les trois résistances R1 à R3 ont leur première extrémité 2 reliée au premier conducteur ligne Y1 et leur seconde extrémité 3 est reliée respectivement au premier, second et troisième conducteur colonne X1, X2 et X3.

Le dispositif magnétique de lecture 1 comporte un générateur de tension 5, produisant une tension continue de commande VC destinée à être appliquée aux bornes des résistances R1 à R9.

Suivant une caractéristique de l'invention, chaque conducteur ligne Y1 à Y3 reçoit l'une des polarité de la tension de commande VC par l'intermédiaire d'un organe de commutation I1, I2, I3. Chaque organe de commutation peut être mis soit à l'état "bloqué soit à l'état "passant" : dans l'état "bloqué", l'organe de commutation I1 à I3 présente une très grande impédance, et dans l'état "passant" il présente une très faible impédance.

Le générateur de tension 5 délivre les deux polarités de la tension de commande VC par deux sorties 4, 6 dont la première est reliée à une tension de référence telle que la masse par exemple; la seconde sortie 6 délivrant la seconde polarité est reliée à une entrée E1 à E3 de tous les organes de commutation I1 à I3.

Les sorties S1,S2,S3 des organes de commutation I1,I2,I3 sont reliées chacune à un conducteur ligne Y1, Y2, Y3.

Les organes de commutation I1 à I3 remplissent une fonction d'interrupteur, ils ouvrent ou ferment le circuit entre la seconde polarité de la tension de commande VC et chacun des conducteurs lignes Y1 à Y3. Ces organes de commutation peuvent être constitués par différents composants en eux-mêmes classiques, par exemple les contacts d'un relais électromécanique; mais pour des questions de vitesse de commutation, il peut être plus avantageux d'utiliser des portes électroniques, de type analogique par exemple qui peuvent présenter des états "passant" ou "bloqué" compatibles avec ceux qui sont nécessaires dans la présente application, avec des transitions rapides.

En effet, la résistance R1 à R9 des éléments magnéto-résistifs est couramment de l'ordre de 10 ohms. Sous une tension de commande VC de l'ordre de 1 volt par exemple, le courant nominal dans chaque résistance R1 à R9 est de l'ordre de 0,1 ampère, et les variations du courant dues au champ magnétique à lire peuvent atteindre quelques % du courant nominal selon le type d'élément magnéto-résistif. Il est donc nécessaire pour une bonne précision de mesure que le générateur de tension 5 comporte une faible résistance interne, et que tous les éléments disposés en série avec les résistances R1 à R9 des éléments magnéto-résistifs présentent une résistance faible.

Avec une telle disposition, on active ligne par ligne L1, L2, L3 les têtes de lecture T1 à T9 sélectionnées, en appliquant la tension de commande VC uniquement aux résistances R1 à R9 correspondantes, en commandant l'état "passant" de l'organe de commutation I1 à I3 correspondant. A cet effet, une entrée de commande Ec1 à Ec3 de chacun des organes de commutation est reliée à un dispositif de commande et de synchronisation (10) en lui-même classique; ce dernier délivre par exemple un signal de commande vers l'organe de commutation à rendre "passant", et en l'absence d'un tel signal chaque organe de commutation conserve l'état "bloqué".

Suivant une autre caractéristique de l'invention, d'une part tous les conducteurs colonnes X1, X2, X3 sont portés en permanence au potentiel de la tension de référence, c'est à dire à la masse dans l'exemple présent, ce potentiel correspondant à la première polarité de la tension de commande VC; et d'autre part tous les conducteurs colonnes sont reliés chacun en permanence à un capteur de courant A1,A2,A3.

Dans l'exemple non limitatif, les capteurs de courant sont montés en série entre chaque conducteur colonne X1 à X3 et la première polarité de la tension de commande. En conséquence ces capteurs de courant A1 à A3 sont constitués chacun par un amplificateur 9 du type amplificateur opérationnel par exemple, suivant un montage classique qui permet, avec un amplificateur ayant un gain suffisant, d'obtenir une impédance d'entrée quasiment nulle. Dans l'exemple non limitatif décrit, chaque amplificateur 9 comporte une entrée positive +, une entrée négative - ; et une sortie 01,02,03, avec une résistance de contre-réaction Cr connectée entre l'entrée négative - et la sortie 01 à 03. Chaque conducteur colonne X1 à X3 est relié à une entrée négative - d 'un amplificateur 9. Chaque entrée positive + d'amplificateur est reliée au potentiel de la masse, de telle manière que ce potentiel est reporté sur chaque conducteur colonne X1 à X3 à travers une très faible impédance. Les sorties 01 à 03 des amplificateurs 9 délivrent un signal en tension dont l'amplitude est fonction du courant qui circule dans les conducteurs colonnes X1 à X3.

Dans cette configuration, l'adressage d'une ligne L1 à L4 de têtes de lecture sélectionnées s'effectue en commandant la mise à l'état "passant" de l'organe de commutation I1 à I3 correspondant. La tension de commande est alors appliquée aux résistances R1 à R9 de cette ligne sélectionnée, d'où résulte, d'une part dans le conducteur ligne Y1 à Y3 correspondant un courant ligne iL qui est la somme des courants dans toutes les résistances R1 à R9 de cette ligne ; et d'où résulte d'autre part dans chaque conducteur colonne X1 à X3, un courant i1 à i3 propre à chaque résistance R1 à R9 c'est à dire à chacune des têtes de lecture T1 à T9 qui forment la ligne L1 à L3 adressée. Ainsi par exemple, si la ligne adressée est la première ligne L1 : le courant i1 qui circule dans le premier conducteur colonne X1 correspond au courant de la première tête de lecture T1; les courant i2 et i3 qui circulent respectivement dans le second et le troisième conducteur colonne X2 et X3 correspondent respectivement à la seconde et à la troisième tête T2 et T3. Quand c'est le second organe de commutation I2 qui est "passant" les autres organes I1, I3 sont "bloqués", et les courants i1,i2 et i3 correspondent respectivement à la quatrième, cinquième et sixième tête de lecture T4,T5,T6; et ces courants sont ceux qui proviennent des septième , huitième et neuvième têtes de lecture T7,T8,T9 quand le troisième organe de commutation 13 est rendu "passant".

La tension de commande Vc étant appliquée à travers une faible impédance au conducteur ligne Y1 à Y3 de la ligne L1 à L3 sélectionnée, alors que les autres conducteurs lignes des lignes non sélectionnées sont en série avec une très haute impédance, les résistances R1 à R9 des têtes de lecture non sélectionnées n'ont en pratique aucune influence sur le courant i1 à i3 qui circule dans les conducteurs colonnes X1 à X3 et qui est injecté dans les amplificateurs 9.

Les courants i1 à i3 sont convertis en signaux de tension ST1 à ST3 par les amplificateurs 9, et ces signaux de tension sont chargés d'une manière en elle-même classique, dans un registre d'acquisition 15. Le registre d'acquisition 15 est un registre à décalage par exemple, comportant des cases de stockage CS1 à CS3 capables de stocker chacune une valeur analogique. Le registre d'acquisition 15 comporte autant de case de stockage CS1 à CS3 qu'il y a de conducteurs colonne X1 à X3, et chaque sortie 01 à 03 d'amplificateur est relié à une telle case de stockage.

Les chargements des signaux de tension ST1 à ST3 sont accomplis simultanément pour toute une ligne L1 à L3, et entre chaque chargement dans le registre d'acquisition 15, les données contenues dans ce dernier peuvent être transférées dans un dispositif de stockage 16, sous la commande du dispositif de commande et de synchronisation 10. Il est ainsi possible d'adresser les têtes de lecture T1 à T9 ligne par ligne L1 à L3, et notamment de façon cyclique, à une vitesse qui est liée à la dimension des informations inscrites sur une bande magnétique à lire et à la vitesse de déplacement de cette bande.

Il est bien entendu possible d'utiliser de nombreuses autres méthodes, toutes connues du spécialiste, pour réaliser l'acquisition des signaux de tension ST1 à ST3 délivrés par les amplificateurs A1 à A3 : par exemple les sorties d'amplificateurs peuvent être reliées à des dispositifs d'acquisition (non représenté) indépendants les uns des autres.

Dans la présente description, l'appellation "ligne" ou "colonne" donnée aux conducteurs est arbitraire et ne préjuge pas de leur orientation. Il est à noter en outre que les conducteurs lignes ne sont pas nécessairement perpendiculaires aux conducteurs colonnes, et que d'autre part la répartition des fonctions attribuées aux conducteurs lignes et colonnes pourrait être inversée entre ces derniers.

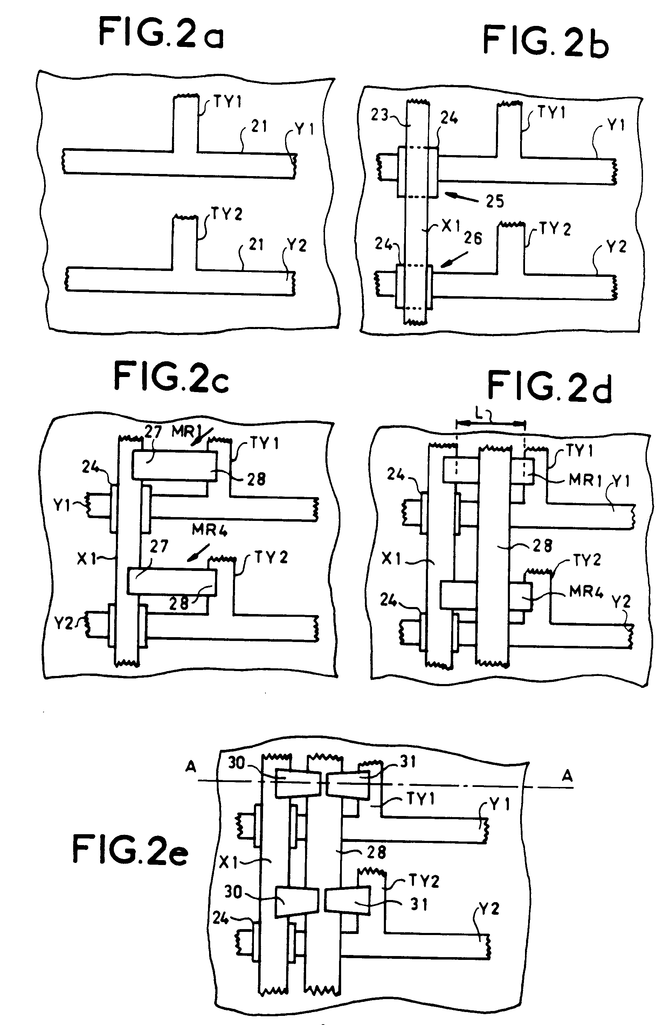

Les figures 2a à 2e représentent des étapes d'un procédé de réalisation de têtes de lecture magnéto-résistives, par exemple par une technologie classique de film en couches minces. Ce procédé est indiqué uniquement à titre d'exemple non limitatif, pour montrer qu'il est possible d'alimenter chaque tête de lecture entre un conducteur ligne et un conducteur colonne comme montré à la figure 1.

La figure 2a est une vue de dessus qui illustre la réalisation sur un substrat 20 en verre ou en silicium isolant par exemple, de deux conducteurs 21 parallèles, constituant deux conducteurs lignes Y1, Y2; ces deux conducteurs lignes ayant été réalisés par exemple par gravure d'une couche électriquement conductrice, déposée sur le substrat 20. Chaque conducteur ligne Y1,Y2 comporte un tronçon TY1, TY2 perpendiculaire à la direction générale des conducteurs lignes.

La figure 2b montre qu'un troisième conducteur 23 perpendiculaire aux deux conducteurs lignes Y1,Y2 est formé au dessus de ces derniers. Ce troisième conducteur 23 constitue un conducteur colonne, le premier conducteur colonne X1 par exemple. Le premier conducteur colonne X1 croise et recouvre les conducteurs lignes Y1,Y2, desquels il est isolé électriquement par une couche isolante 24 qui après gravure ne subsiste qu'aux intersections 25, 26.

La figure 2c illustre la réalisation des éléments magnéto-résistifs MR1,MR4 des têtes de lecture T1,T4 montrées à la figure 1.

Ces éléments magnéto-résistif MR1,MR4 sont du type comportant une couche magnéto-résistive par exemple en Permalloy (Fe₈₀Ni₂₀), et une couche ferrimagnétique (pour la polarisation de la couche magnéto-résistive) par exemple en Feₓ Mn_{y}.

Ces deux couches sont réalisées successivement de manière à être superposées (perpendiculairement au plan de la figure) et à s'étendre depuis chaque tronçon TY1, TY2 jusqu'au conducteur colonne X1. Une première extrémité 27 de ces couches superposées est en contact électrique avec le premier conducteur colonne X1 qu'elle recouvre partiellement ; et leur seconde extrémité 28 est en contact avec le tronçon de ligne TY1, TY2 qu'elle recouvre partiellement. La distance entre le premier conducteur colonne X1 et les tronçons TY1,TY2 représente la longueur active des éléments magnéto-résistif MR1,MR4, c'est-à-dire la longueur L des résistances R1, R4.

La figure 2d représente une étape suivante dans laquelle un espaceur 28 est formé au dessus d'une partie centrale de chaque élément magnéto-résistif MR1, MR4. En fait l'espaceur 28 est commun aux deux têtes de lecture T1,T4 : il est constitué par une bande parallèle au premier conducteur colonne X1 et qui s'étend entre ce dernier et les tronçons TY1,TY2. L'espaceur 28 est constitué en un matériau non magnétiqure et électriquement isolant, en alumine Al₂ O₂ par exemple ou en Si O₂.

La figure 2e illustre une dernière étape dans laquelle deux pôles magnétiques 30, 31 séparés par un entrefer 32, ont été réalisés au dessus de l'espaceur 28 et des éléments magnéto-résistifs pour chaque tête de lecture T1,T4. Ces pôles magnétiques 30, 31 constituent un circuit magnétique en anneau incorporant l'élément magnéto-résistif MR1, MR4 et qui permet de guider le flux magnétique jusqu'à ce dernier.

Les pôles magnétiques 30,31 sont en un matériau magnétique tel que le Sendust par exemple, et ils sont réalisés de façon en elle-même classique par dépôts successifs et usinages de couches de Sendust, comme décrit par exemple dans la demande de brevet français 86 14974 au nom de THOMSON-CSF.

La figure 3 montre la tête de lecture T1 par une vue en coupe selon un axe A-A de la figure 2e.

On retrouve sur la figure 3 les éléments déjà cités en référence aux figures 2a à 2e.

Le substrat 20 porte le premier conducteur colonne X1 et le premier tronçon TY1 entre lesquels s'étend le premier élément magnéto-résistif MR1. L'élément magnéto-résistif MR1 comporte une couche 36 magnéto-résistive et une couche 35 ferrimagnétique disposée entre le substrat 20 et la couche 36 magnéto-résistive. Une partie centrale de l'élément magnéto-résistif porte l'espaceur 28 autour duquel sont formés les pôles magnétiques 30, 31. Les pôles magnétiques 30,31 permettent de guider jusqu'à l'élément magnéto-résistif MR1, le flux magnétique inscrit sur une bande magnétique 40 passant à proximité de l'entrefer 32.

La structure de tête de lecture et son mode de réalisation montrés aux figures 2a à 2e et à la figure 3 sont donnés à titre d'exemple non limitatif. En particulier le mode d'adressage des tête de lecture T1 à T9, décrit en référence à la figure 1, peut s'appliquer avantageusement à tous les types d'éléments magnéto-résistifs par exemple les structures magnéto-résistives multicouches à effet magnéto-résistif "géant", dès lors que le nombre de têtes de lecture est assez important pour que l'on cherche à diminuer le nombre des conducteurs de connexions, et que l'on cherche à annuler l'effet des têtes de lecture non selectionnées sur le courant des têtes sélectionnées.

## Revendications

1. Dispositif magnétique de lecture, comportant une pluralité de têtes magnétiques de lecture (T1 à T9), un générateur de tension (5) délivrant une tension de commande, chaque tête de lecture (T1 à T9) comprenant un élément magnéto-résistif (MR) présentent une résistance électrique (R1 à R9) variable en fonction d'un champ magnétique extérieur, caractérisé en ce qu'il comporte un réseau de conducteurs lignes (Y1 à Y3) croisés avec un réseau de conducteurs colonnes (X1 à X3), les têtes de lecture (T1 à T9) étant situées chacune sensiblement à une intersection d'un conducteur ligne avec un conducteur colonne, chaque résistance (R1 à R9) étant reliée d'une part par une première extrémité (2) au conducteur ligne (Y1 à Y3) de l'intersection correspondante, et d'autre part au conducteur colonne (X1 à X3) de la même intersection par une seconde extrémité (3), et en ce que chaque conducteur ligne (Y1 à Y3) reçoit une première polarité de la tension de commande par l'intermédiaire d'un organe de commutation (I1 à I3), et en ce que chaque conducteur colonne (X1 à X3) est relié d'une part à la seconde polarité de la tension de commande et d'autre part à un capteur de courant (A1 à A3).

2. Dispositif de lecture selon la revendication 1, caractérisé en ce que l'organe de commutation (I1 à I3) est du type comportant soit un état "bloqué, dans lequel il présente une haute impédance, soit un état "passant" dans lequel il présente une basse impédance.

3. Dispositif de lecture selon l''une des revendications précédentes, caractérisé en ce que le capteur de courant (A1 à A3) est monté en série entre le conducteur colonne (X1 à X3) et la seconde polarité de la tension de commande.

4. Dispositif de lecture selon l'une quelconque des revendications 2 ou 3, caractérisé en ce qu'il comporte des moyens (10) pour commander l'état "passant" de l'organe de commutation (I1 à I3) correspondant à une ligne (L1 à L3) de tête de lecture (T1 à T9) sélectionnées, tout en commandant l'état "bloqué" des autres organes de commutation.

5. Dispositif de lecture selon la revendication 4, caractérisé en ce qu'il comporte des moyens (10, 15) pour adresser les têtes de lecture (T1 à T9) sélectionnées ligne par ligne, de manière cyclique.

6. Dispositif de lecture selon l'une quelconque des revendications 4 ou 5, caractérisé en ce qu'il comporte des moyens (10,15) pour stocker simultanément des signaux (ST1 à ST3) délivrés par chacune des têtes de lecture (T1 à T9) d'une ligne (L1 à L3) sélectionnée.

7. Dispositif de lecture selon l'une des revendications précédentes, caractérisé en ce que les conducteurs lignes et colonnes (Y1 à Y3 et X1 à X3) et les têtes de lectures (T1 à T9) sont réalisés sur un même substrat (20), et en ce que chaque élément magnéto-résistif (MR) comporte une couche (36) magnéto-résistive dont une première extrémité (27) est reliée à un conducteur colonne (X1 à X3) et dont la seconde extrémité (28) est reliée à un conducteur ligne (Y1 à Y3).

8. Dispositif de lecture selon la revendication 7 caractérisé en ce qu'une longueur (L) de la couche magnéto-résistive (36) constitue la résistance électrique (R1 à R9).

9. Dispositif de lecture selon la revendication 7, caractérisé en ce que la couche magnéto-résistive (36) est sensiblement parallèle au substrat (20).

10. Dispositif de lecture selon l'une des revendications 7 ou 8, caractérisé en ce qu'il comporte une couche (35) ferrimagnétique de polarisation disposée entre le substrat ( 20) et la couche (36) magnéto-résistive.

11. Dispositif de lecture selon l'une quelconque des revendications 7, 8, 9 ou 10, caractérisé en ce que chaque couche (36) magnéto-résistive est reliée à un conducteur ligne (Y1 à Y3) par l'intermédiaire d'un tronçon (TY1, TY2) disposé parallèlement aux conducteurs colonnes (X1 à X3).

## Patentansprüche

1. Magnetische Lesevorrichtung mit mehreren Lese-Magnetköpfen (T1 bis T9), einem Spannungsgenerator (5), der eine Steuerspannung liefert, wobei jeder Lesekopf (T1 bis T9) ein magnetoresistives Element (MR) enthält, das einen abhängig von einem äußeren Magnetfeld veränderlichen elektrischen Widerstand (R1 bis R9) hat, dadurch gekennzeichnet, daß es eine Gruppe von Zeilenleitern (Y1 bis Y3) enthält, die mit einer Gruppe von Spaltenleitern (X1 bis X3) überkreuzt sind, wobei die Leseköpfe (T1 bis T9) im wesentlichen jeweils bei einem Überschneidungspunkt eines Zeilenleiters mit einem Spaltenleiter liegen, wobei jeder Widerstand (R1 bis R9) einerseits mit einem ersten Ende (2) an den Zeilenleiter (Y1 bis Y3) des entsprechenden Überschneidungspunkts und andererseits mit einem zweiten Ende (3) an den Spaltenleiter (X1 bis X3) des gleichen Überschneidungspunkts angeschlossen ist, und daß jeder Zeilenleiter (Y1 bis Y3) an einen ersten Pol der Steuerspannung über ein Schaltorgan (I1 bis I3) gelegt ist und daß jeder Spaltenleiter (X1 bis X3) einerseits an den zweiten Pol der Steuerspannung und andererseits an einen Stromaufnehmer (A1 bis A3) gelegt ist.

2. Lesevorrichtung nach Anspruch 1, dadurch gekennzeichnet, daß das Schaltorgan (I1 bis I3) ein Schaltorgan des Typs ist, der einen Zustand "gesperrt" aufweist, indem es eine hohe Impedanz hat, oder einen Zustand "durchlassend" aufweist, indem es eine niedrige Impedanz hat.

3. Lesevorrichtung nach einem der vorhergehenden Ansprüche, dadurch gekennzeichnet, daß der Stromaufnehmer (A1 bis A3) in Serie zwischen dem Spaltenleiter (X1 bis X3) und dem zweiten Pol der Steuerspannung liegt.

4. Lesevorrichtung nach einem der Ansprüche 2 oder 3, dadurch gekennzeichnet, daß sie Mittel (10) aufweist, um den Zustand "durchlassend" einer ausgewählten Zeile (L1 bis L3) von Leseköpfen (T1 bis T9) unter Steuerung des Zustands "gesperrt" der anderen Schaltorgane zu steuern.

5. Lesevorrichtung nach Anspruch 4, dadurch gekennzeichnet, daß sie Mittel (10, 15) zum zeilenweisen zyklischen Adressieren der ausgewählten Leseköpfe (T1 bis T9) enthält.

6. Lesevorrichtung nach einem der Ansprüche 4 oder 5, dadurch gekennzeichnet, daß sie Mittel (10, 15) zum gleichzeitigen Speichern von Signalen (ST1 bis ST3) enthält, die von jedem der Leseköpfe (T1 bis T9) einer ausgewählten Zeile (L1 bis L3) geliefert werden.

7. Lesevorrichtung nach einem der vorhergehenden Ansprüche, dadurch gekennzeichnet, daß die Zeilenleiter und die Spaltenleiter (Y1 bis Y3 und X1 bis X3) und die Leseköpfe (T1 bis T9) auf dem gleichen Substrat (20) hergestellt sind, und daß jedes magnetoresistive Element (MR) eine magnetoresistive Schicht (36) aufweist, bei der ein erstes Ende (27) mit einem Spaltenleiter (X1 bis X3) verbunden ist und deren zweites Ende (28) mit einem Zeilenleiter (Y1 bis Y3) verbunden ist.

8. Lesevorrichtung nach Anspruch 7, dadurch gekennzeichnet, daß eine Länge (L) der magnetoresistiven Schicht (36) den elektrischen Widerstand (R1 bis R9) bildet.

9. Lesevorrichtung nach Anspruch 7, dadurch gekennzeichnet, daß die magnetoresistive Schicht (36) im wesentlichen parallel zum Substrat (20) verläuft.

10. Lesevorrichtung nach einem der Ansprüche 7 oder 8, dadurch gekennzeichnet, daß sie eine ferromagnetische Polarisationsschicht (35) enthält, die zwischen dem Substrat (20) und der magnetoresistiven Schicht (36) angeordnet ist.

11. Lesevorrichtung nach einem der Ansprüche 7, 8, 9 oder 10, dadurch gekennzeichnet, daß jede magnetoresistive Schicht (36) über einen parallel zu den Spaltenleitern (X1 bis X3) verlaufenden Abschnitt (TY1, TY2) mit einem Zeilenleiter (Y1 bis Y3) verbunden ist.

## Claims

1. Magnetic read device, including a plurality of magnetic read heads (T1 to T9), a voltage generator (5) delivering a control voltage, each read head (T1 to T9) comprising a magnetoresistive element (MR) exhibiting an electrical resistance (R1 to R9) which is variable as a function of an external magnetic field, characterized in that it includes a network of row conductors (Y1 to Y3) intersecting with a network of column conductors (X1 to X3), the read heads (T1 to T9) each being situated substantially at an intersection of a row conductor with a column conductor, each resistor (R1 to R9) being linked, on the one hand, by a first end (2) to the row conductor (Y1 to Y3) of the corresponding intersection and, on the other hand, to the column conductor (X1 to X3) of the same intersection by a second end (3), and in that each row conductor (Y1 to Y3) receives a first polarity of the control voltage via a switching member (I1 to I3), and in that each column conductor (X1 to X3) is linked, on the one hand, to the second polarity of the control voltage and, on the other hand, to a current sensor (A1 to A3).

2. Read device according to Claim 1, characterized in that the switching member (I1 to I3) is of the type including either an "off" state, in which it exhibits a high impedance, or an "on" state in which it exhibits a low impedance.

3. Read device according to one of the preceding claims, characterized in that the current sensor (A1 to A3) is mounted in series between the column conductor (X1 to X3) and the second polarity of the control voltage.

4. Read device according to either of Claims 2 and 3, characterized in that it includes means (10) for setting the "on" state of the switching member (I1 to I3) corresponding to a row (L1 to L3) of a read head (T1 to T9) selected, while setting the "off" state of the other switching members.

5. Read device according to Claim 4, characterized in that it includes means (10, 15) for addressing the read heads (T1 to T9) which are selected row by row, in a cyclic way.

6. Read device according to either of Claims 4 and 5, characterized in that it includes means (10, 15) for simultaneously storing signals (ST1 to ST3) which are delivered by each of the read heads (T1 to T9) of a selected row (L1 to L3).

7. Read device according to one of the preceding claims, characterized in that the row and column conductors (Y1 to Y3 and X1 to X3) and the read heads (T1 to T9) are produced on the same substrate (20), and in that each magnetoresistive element (MR) includes a magneto-resistive layer (36), a first end (27) of which is linked to a column conductor (X1 to X3) and the second end (28) of which is linked to a row conductor (Y1 to Y3).

8. Read device according to Claim 7, characterized in that a length (L) of the magnetoresistive layer (36) constitutes the electrical resistance (R1 to R9).

9. Read device according to Claim 7, characterized in that the magnetoresistive layer (36) is substantially parallel to the substrate (20).

10. Read device according to either of Claims 7 and 8, characterized in that it includes a ferrimagnetic polarization layer (35) arranged between the substrate (20) and the magnetoresistive layer (36).

11. Read device according to any one of Claims 7, 8, 9 and 10, characterized in that each magnetoresistive layer (36) is linked to a row conductor (Y1 to Y3) via a segment (TY1, TY2) arranged parallel to the column conductors (X1 to X3).
